Europäisches Patentamt

European Patent Office

Office européen des brevets

(11) Publication number: **0 469 738 A2**

# EUROPEAN PATENT APPLICATION

(21) Application number: **91306384.8**

(22) Date of filing: **15.07.91**

(30) Priority: **03.08.90 GB 9017068**

(43) Date of publication of application:
**05.02.92 Bulletin 92/06**

(84) Designated Contracting States:
**DE FR GB**

(51) Int. Cl.⁵: **H03K  23/50**, H03K 23/58,
H03L 7/06

(71) Applicant: **MARCONI INSTRUMENTS LIMITED**
**Longacres Hatfield Road**
**St. Albans Hertfordshire, AL4 0JN(GB)**

(72) Inventor: **Thomas, Neil Edwin**
**29 Salisbury Avenue**
**St. Albans, Hertfordshire AL1 4UB(GB)**

(74) Representative: **Hoste, Colin Francis**
**The General Electric Company p.l.c. Central**
**Patent Department (Wembley Office) Hirst**
**Research Centre East Lane**
**Wembley, Middlesex HA9 7PP(GB)**

㊴ Low noise frequency divider architecture.

㊲ A frequency divider comprising an input port (4), for receiving an input signal, a counting means (42, 52) and a retiming means (30), the input port (4) being coupled to an input of the retiming means (30), the counting means (42, 52) including first flip-flop means (42) having its clock input coupled to said input port (4), and second flip-flop means (52) having its clock input coupled to an output of said first flip-flop means (42) and an output coupled together with an output of the first flip-flop means (42) via gate means (54) to a control input of the retimer means (30), said counting means (42, 52) selectively enabling the retiming means (30) so that the retiming means (30) changes state on receipt of a cycle of the input signal following enablement whereby the output of the retiming means (30) provides a frequency divided version of the input signal which is synchronised with the input signal.

Fig.5A.

This invention relates to frequency dividers.

Digital frequency dividers are frequently used to manipulate RF signals, e.g. in phase-locked loops. In many systems however the noise performance of the frequency divider limits the system performance. Typical commercially available ECL dividers rarely exhibit a phase noise performance much better than - 150 $\overline{\text{dBc}}$/Hz and low power frequency dividers are frequently much worse. This level of performance can often limit the performance of phase locked loop systems and the divide by $2^n$ (where n is an integer) chain used in signal sources.

The problem with the phase noise performance of a typical divider is that in order to obtain better performance the bias current in the divider needs to be increased (thereby to lower load resistance) - but it cannot be increased without causing a power dissipation problem.

It is an object of the present invention to provide a frequency divider structure wherein the speed of operation can be increased without an undue rise in power dissipation.

According to the present invention there is provided a frequency divider comprising an input port, for receiving an input signal, a counting means and a retiming means, the input port being coupled to an input of the retiming means, the counting means including first flip-flop means having its clock input coupled to said input port, and second flip-flop means having its clock input coupled to an output of said first flip-flop means and an output coupled together with an output of the first flip-flop means via gate means to a control input of the retimer means, said counting means selectively enabling the retiming means so that the retiming means changes state on receipt of a cycle of the input signal following enablement whereby the output of the retiming means provides a frequency divided version of the input signal which is synchronised with the input signal.

The retiming means is synchronised to the input signal and thus controls the noise performance while the remainder of the circuit, which provides the division facility, is run at a lower speed/power so maximising the amount of power available to the critical retiming means. The purpose of the retiming means is to accept a noise jittered output from the counting means and to use this to gate a clock input provided by the input signal. Any convenient circuit may be employed as a retiming means; whilst for simplicity an AND gate arrangement could be employed, it is preferred to use for convenience a flip-flop which follows the output of the counting means but is switched by the next cycle of the input signal following a transition of the counting means output.

As preferred the retimer means comprises a T-type (toggle) flip-flop which has the advantage that when the input is high, the output toggles in response to the clock signal. This then can provide an extra division stage and reduces the total number of division stages by one in order to achieve a desired division ratio.

The flip-flop means comprising the counter means are preferably D-type flip-flops. The outputs of the first and second flip-flop means coupled via gate means, preferably AND gate means, to the control input of the retimer means are so coupled to overcome the problem of the outputs of the flip-flop means meeting the timing requirements of the retimer means.

The invention will now be further explained, and embodiments of the invention described by way of example, with reference to the accompanying drawings, wherein:-

Figure 1 is a schematic block diagram of a first frequency divider;

Figure 2 is a block diagram of an asynchronous counting mechanism for use in the divider of Figure 1;

Figure 3 is a schematic diagram of a T-type (toggle) flip-flop for use in the divider of Figure 1;

Figure 4A is a block diagram of a second frequency divider, and Figure 4B is an associated timing diagram;

Figure 5A is a block diagram of a third frequency divider, which divider is a first embodiment of the present invention, and Figure 5B is an associated timing diagram;

Figure 6 is a block diagram of a fourth frequency divider, which divider is a second embodiment of the present invention;

Figure 7 is a schematic view of a phase locked loop employing a frequency divider in accordance with the invention; and

Figure 8 is a block schematic of a third embodiment of the present invention comprising a programmable frequency divider.

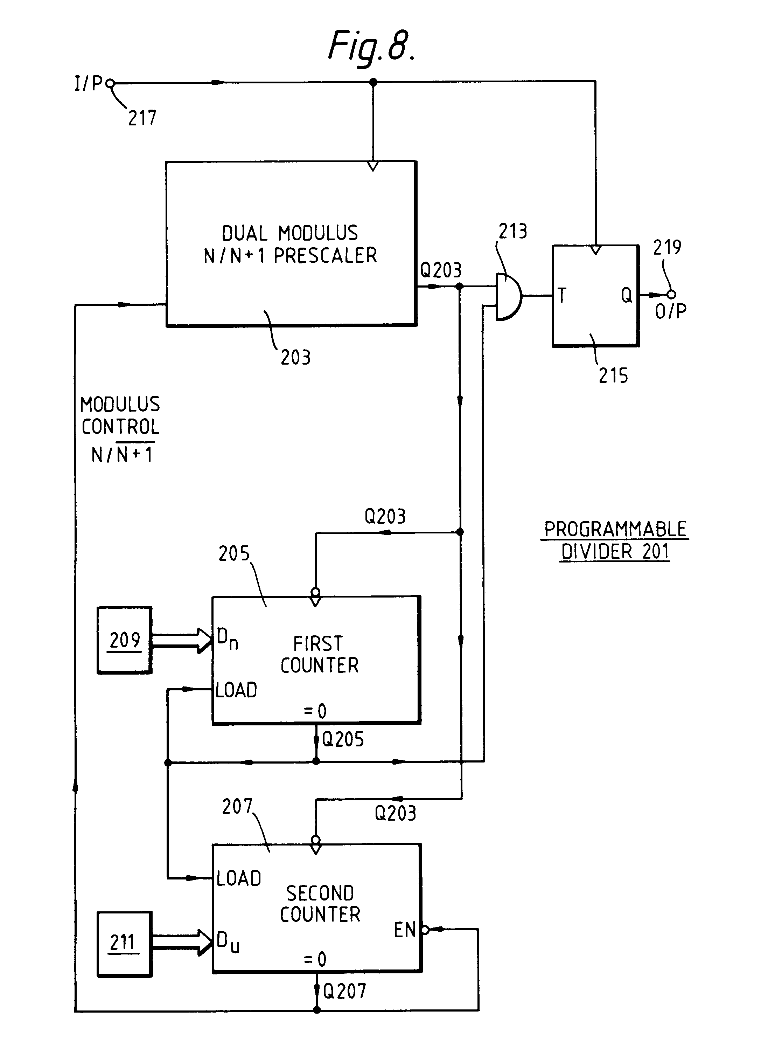

Referring now to the drawings, similar parts are denoted by the same reference numeral. Referring first to Figure 7, this shows a typical application of a frequency divider in accordance with the invention in a phase locked loop 100 wherein a VCO 102 provides an output signal, for example 1GHz, to a frequency divider 2 which divides the frequency and provides an output to a phase comparator 104 where the divided frequency is compared in phase with a reference signal from a source 106 and the result of the comparison is provided via a low pass filter 108 to a control input of the VCO 102.

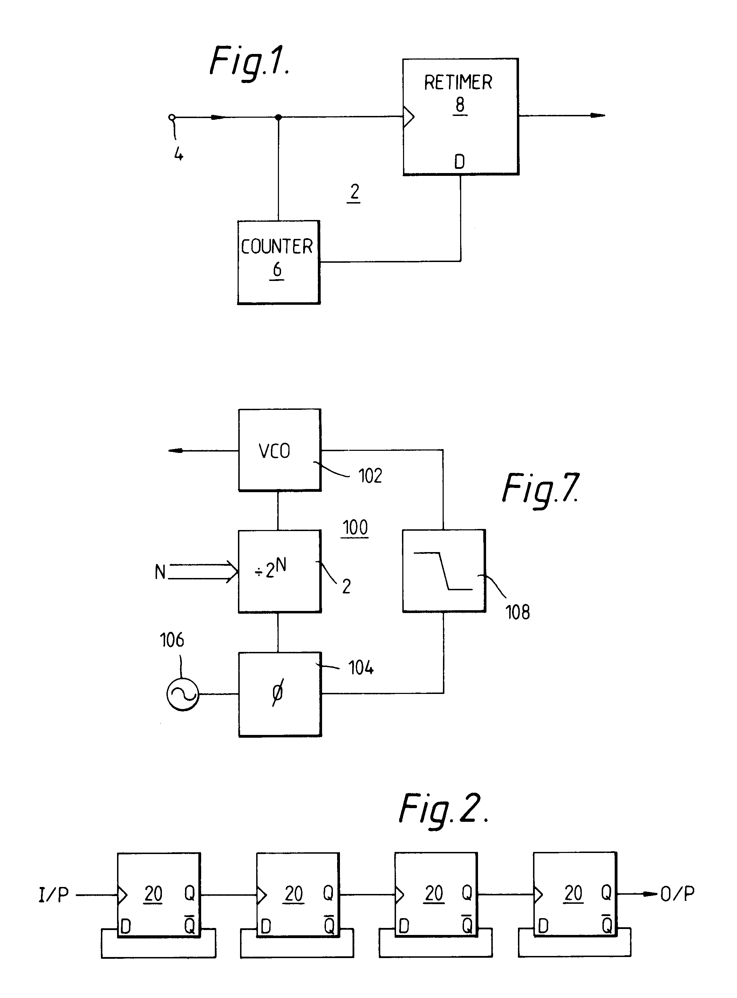

Referring now to Figure 1, the frequency divider 2 has an input port 4 for receiving the input signal, the input signal being fed to the input of a counter mechanism 6 which provides an output which is fed to the control input of a retimer means comprising a D-type flip-flop 8. The input signal is applied to the clock input of the D-type flip-flop 8. Thus the output of the counter which may be a relatively low power counter and thus provides a noisy output is re-timed by the D-type flip-flop whereby the output of the flip-flop is clocked by the leading edge of each cycle of the input signal. Thus the noise in the output of the frequency divider is determined essentially by the noise characteristics of the D-type flip-flop.

The lowest power architecture available for the counter is an asynchronous design (or ripple counter) shown in Figure 2, comprising a chain of D-type flip-flops 20 each having their not Q output connected to the D control input.

The later stages of such a counter do not have to be clocked at as high a rate as the input device so they can sacrifice speed for lower power. However when used in a retimed system as in Figure 1 a problem may arise in certain circumstances because in order to avoid race hazards the total propagation delay through the counter should be less than one cycle of the input signal. Since the ripple counter design uses many series elements in the critical signal route, such propagation delay may be large, rendering the counter unsuitable for some applications. In other words a problem with reducing the speed of the later stages in a ripple counter arises when retiming in the retimer means. The edges provided to the D input of the D-type flip-flop must be positioned within predefined limits with respect to the clock. A slow edge, from a low power stage, may span several high speed input transitions, and so will be ambiguous to the retimer.

An alternative counter architecture is to use a synchronous design where all the elements are simultaneously clocked. The delay is much shorter but all the elements are required to operate at high speed and therefore high power.

In a further development to be described, an asynchronous counter architecture is provided which allows accurate retiming of the signal and which allows the elements of the counter to be designed to have minimal power dissipation. The architecture also reduces the number of flip-flop elements required by one compared to a ripple counter.

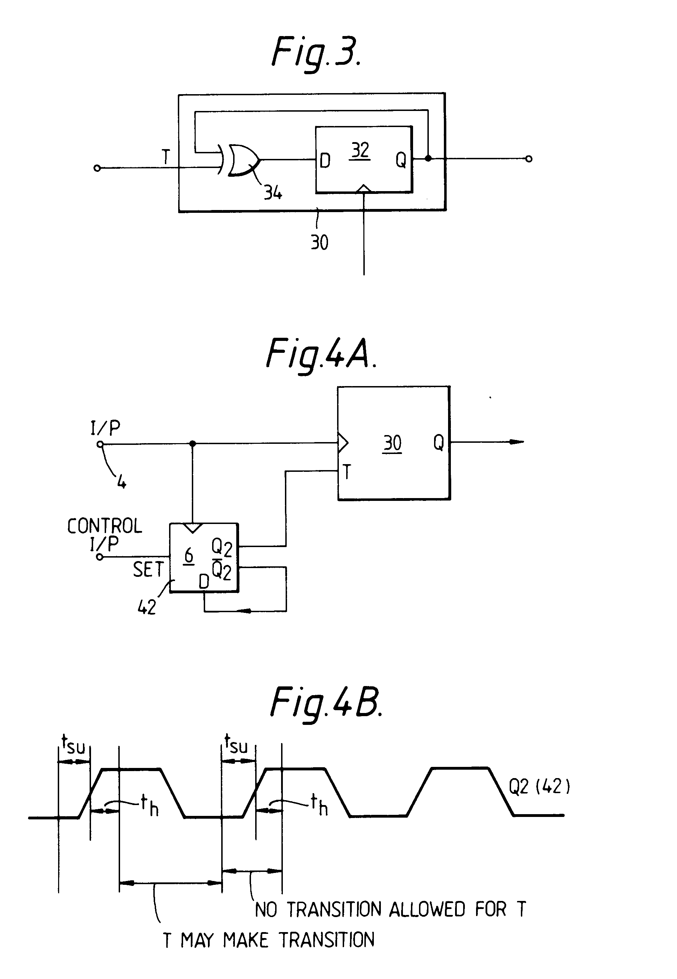

Referring now to Figure 3, this shows the retiming stage of the frequency divider of figure 1 as comprising a T (toggle) flip-flop 30 - i.e. a D type flip-flop 32 with an exclusive OR gate 34 at the input. In a T-type flip-flop, if T is high, the output $Qn+1 = $ not $Qn$, i.e. toggling occurs, whereas if T is low, the output $Qn+1 = Qn$, i.e. the output remains constant.

Thus if the T input is high the circuit divides the clock frequency by 2, if it is low the circuit does nothing. In practice the XOR gate 34, is combined into the input stage of the D type to avoid a full gate delay.

For divide by two operation the T input is simply held high. In order to make the same circuit divide the clock frequency by 4 to give an output having $\frac{1}{4}$ the clock frequency the T input must be high every other cycle and so the T input needs to be driven by a divide by 2 circuit clocked from the same input. This then gives the circuit shown in Figure 4A.

In Figure 4A similar parts to those used in Figures 1 and 3 have the same reference numerals. A counter 6 comprises a D-type flip-flop 42 having its not Q2 output connected to the D input. The $Q_2$ output is coupled to the T input of retimer T flip-flop 30.

For divide by 2 operation the T input of flip-flop 30 must be held high and the $Q_2$ output of D-type flip-flop 42 must be inhibited from operating to avoid spurious signals. Both can be achieved by making the SET input high. For divide by 4 operation the SET input is held low. In other words, for this divide by 4 circuit to be used divide by 2, two things must happen, T must be held high, and the Q2 flip-flop must be inhibited from toggling, to avoid injecting spurious fin/4 onto the output signal. Both things can be accomplished by holding the SET line high.

Q2 must make transitions compatible with the input timing of Q1. Specifically, there is a setup and a hold time during which the T input may not make a transition. Setup and hold are defined with respect to the clock input as shown in Figure 4B.

Thus, there is a timing constraint on the system - the Q2 output must settle before the start of the T input setup time. Clearly Q2 must be a reasonably fast device.

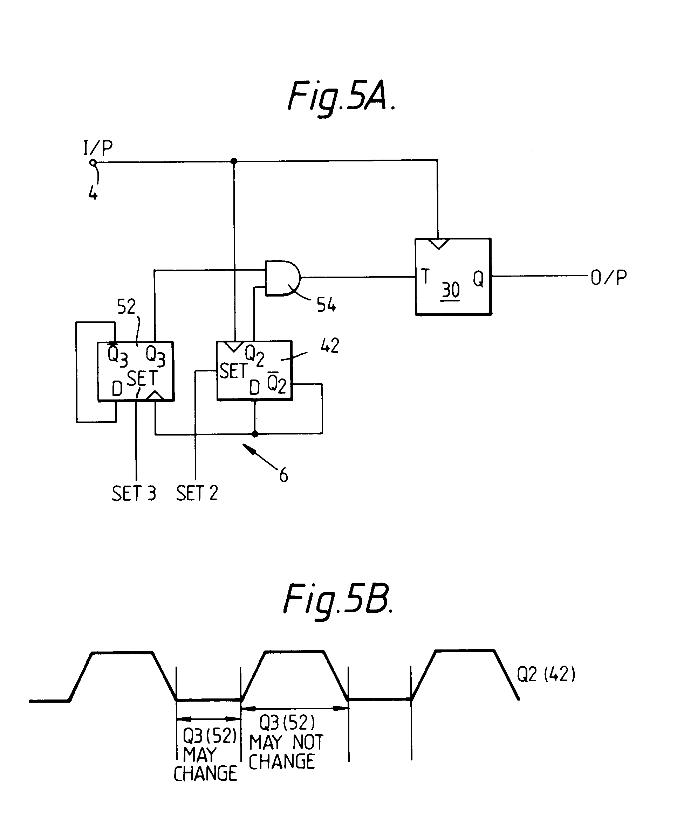

For divide by 8 system the architecture is further expanded as in the first embodiment of the present invention shown in Figure 5A. In Figure 5A, similar parts to those described previously are denoted by similar reference numerals. In Figure 5, the not Q2 output of D flip-flop 42 is coupled to the clock input of D flip-flop 52, the not Q3 output of flip-flop 52 being coupled to the D input. The Q3 output together with the Q2 output of flip-flop 42 are gated in an AND gate 54, the output of gate 54 being coupled to the T input of flip-flop 30.

In this arrangement the T input to retimer 30 is held high for one pulse in four, whereby the output Q1 makes a transition one clock pulse in four, thereby giving an output cycle every eight input clock cycles.

The Q3 output of flip-flop 52 is driven from the not Q2 output of flip-flop 42, not from the input clock. As a result it is operating at half the clock rate and providing an output at ¼ clockrate; it also has a longer time to settle so the Q3 flip-flop can be run at lower power.

Synchronisation of the slow edges on Q3 with the tight timing required by T is achieved by the AND gate 52.

Assuming that the timing of Q2 and T is already correct as in Figure 4B, then the timing conditions can be met as shown in Figure 5B.

While Q2 output is low, gate 54 blocks any change occurring on Q3 to T. The timing of Q2 and Q3 is arranged such that Q3 may make transitions only during Q2 low time. There are two important things to note about this condition:

(1) it is local, it does not involve T or the input clock; (2) the Q2 low time is longer than the 30 T input not setup not hold time. (1) implies that timing calculations need not cover the whole chip, i.e. the process is simplified. (2) implies that Q3 can be slower than Q2 as it has more time to make the transition.

Figure 5A can be made to divide by 2 by SET2 = 1; SET3 = 1; by 4 by SET3 = 1, SET2 = 0and by 8 by 1 both sets inactive.

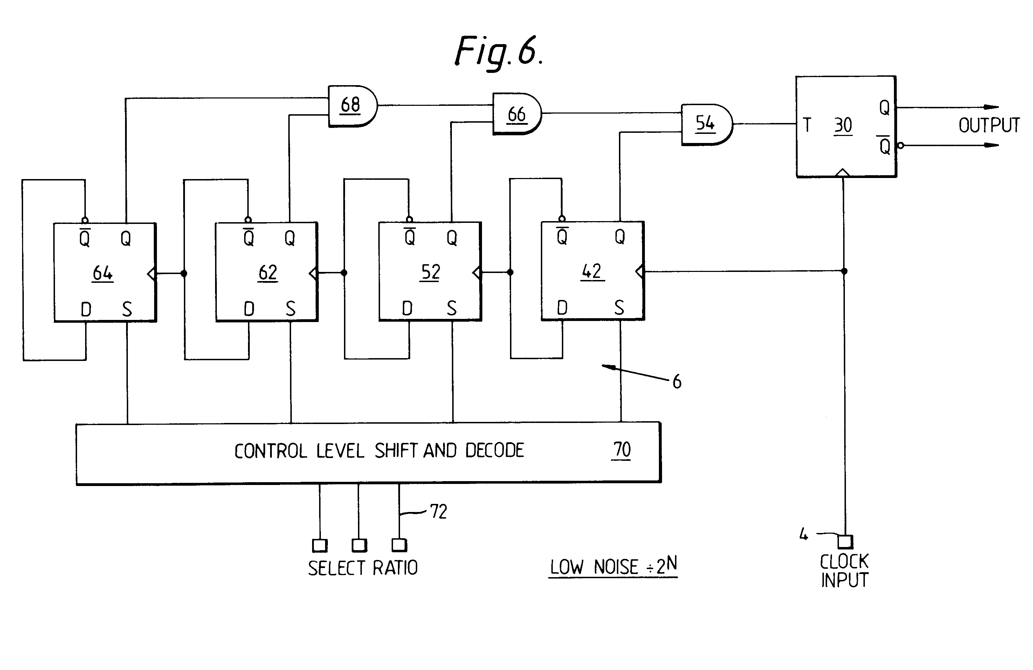

Referring now to Figure 6, this shows a second embodiment of the present invention in which a multistage counter mechanism of any desired length (shown as four) may be employed.

The not Q output of flip-flop 52 is coupled to the clock input of a further flip-flop 62 similar to flip-flop 52, the not Q output of flip-flop 62 in turn being coupled to the clock input of a similar flip-flop 64. The Q outputs of flip-flops 62, 64 are gated in an AND gate 68, the output of AND gate 68 gating the Q output of flip-flop 52 in AND gate 66, the output of which is applied to gate 54. A control level shift and decode circuit 70 is coupled to receive the division ratio provided by a select input 72. The timing is iterative. The Q output of flip-flop 62 may make a transition only when the Q output of flip-flop 52 is low - again a local timing constraint. Any number of stages can be added.

Dividing by less than the maximum is achieved by holding the further stages set. All stages set = divide by 2. All stages not set = divide by $2^n$.

Referring to figure 8, this shows a third embodiment of the present invention comprising a programmable divider 201. The divider 201 comprises a dual modulus N/N + 1 prescaler 203 the output Q203 of which goes active for one clock cycle every N or N + 1 input clocks, first and second preloadable counters 205, 207 each of which is a down counter which decrements by one count for every inactive-going transition of Q203, data sources 209, 211 for the first and second counters 205, 207 respectively, an AND gate 213, and a retimer comprising a T-type flip-flop 215. The divider 201 has input 217 and output 219 ports.

In operation of the divider 201, assuming the prescaler 203 is set to divide by N, when the count of counter 205 is zero the = 0 output Q205 of counter 205 goes active. On the next transition of Q203 counter 205 is loaded with the contents of data source 209 so as to have a count of Dn. Thus, the = 0 output Q205 of counter 205 goes active once every Dn transitions of Q203, or every N x Dn input clocks. Thus, the divisor of the programmable divider 201 is N x Dn.

Changing the value of Dn by one will alter the divisor of the programmable divider 201 by N. The second counter 207 together with data source 211 are provided to interpolate these steps of N counts down to steps of 1 count.

If it is desired that the programmable divider 201 have a divisor which is a multiple of N, i.e. Dn x N, then the contents Du of data source 211 is set to zero. Counter 207 is therefore loaded with zero. The output Q207 of counter 207 therefore goes active, which disables counter 207 and sets prescaler 203 to divide by N.

If it is desired that the programmable divider 201 have a divisor which is not a multiple of N, this is achieved by setting Du to an appropriate value. For example, if it is desired that the divider 201 have a divisor Dn x N + 1, then Du is set to one. Counter 207 is therefore loaded with one, output Q207 goes inactive, counter 207 is enabled to count, and prescaler 203 instructed to divide by N + 1. The next transition of Q203, which occurs after N + 1 input clocks, sets counter 207 to a count of zero. Counter 207 is now disabled, and the remainder of the Dn cycles of Q203 consist of N and not N + 1 input clocks. The divisor of divider 201 is thus 1 x (N + 1) + (Dn - 1) x N = N x Dn + 1. The general divisor of divider 201 can therefore be written as Du x (N + 1) + (Dn - Du) x N = N x Dn + Du.

Whilst the prescaler 203, AND gate 213, and retimer 215 must be implemented in logic capable of running at the speed of the input clock, the first and second counters 205, 207 may run N times slower, and so implemented in slower logic. This results in the timing of the output Q205 being undefined with respect to the input clock. The output Q205 may thus not be used as an input for the retimer 215 directly. The timing of output Q205 is therefore qualified in AND gate 213 by the output Q203 of prescaler 203, the output of AND gate 213 passing to the retimer 215.

## Claims

1. A frequency divider comprising an input port (4 or 217), for receiving an input signal, a counting means (42, 52 or 42, 52, 62, 64 or 203, 205, 207) and a retiming means (30 or 215), the input port (4 or 217) being coupled to an input of the retiming means (30 or 215), the counting means (42, 52 or 42, 52, 62, 64 or 203, 205, 207) including first flip-flop means (42 or 203) having its clock input coupled to said input port (4 or 217), and second flip-flop means (52 or 52, 62, 64 or 205) having its clock input coupled to an output of said first flip-flop means (42 or 203) and an output coupled together with an output of the first flip-flop means (42 or 203) via gate means (54 or 54, 66, 68 or 213) to a control input of the retimer means (30 or 215), said counting means (42, 52 or 42, 52, 62, 64 or 203, 205, 207) selectively enabling the retiming means (30 or 215) so that the retiming means (30 or 215) changes state on receipt of a cycle of the input signal following enablement whereby the output of the retiming means (30 or 215) provides a frequency divided version of the input signal which is synchronised with the input signal.

2.  A frequency divider as claimed in Claim 1 wherein the retiming means (30 or 215) comprises a flip-flop (30 or 215) and said input port (4 or 217) is coupled to the clock input of the flip-flop (30 or 215) and said control input of the retimer means (30 or 215) comprises the signal input of the flip-flop (30 or 215).

3.  A frequency divider as claimed in Claim 2 wherein the flip-flop (30 or 215) of the retiming means (30 or 215) is a T-type flip-flop (30 or 215) whereby to provide a further stage of division of the input signal, the flip-flop (30 or 215) thus forming a further stage of the counting means (42, 52 or 42, 52, 62, 64 or 203, 205, 207).

4.  A frequency divider as claimed in any one of Claims 1 to 3 wherein: said first flip-flop means (42) comprises a first D-type flip-flop (42), whose Q output is connected in a feedback loop to its D input; and said second flip-flop means (52 or 52, 62, 64) comprises a second D-type flip-flop (52) having a clock input coupled to the Q output of the first D-type flip-flop (42), the Q output of the second D-type flip-flop (52) being coupled to its D input, and the Q outputs of the first (42) and second (52) D-type flip-flops being coupled via said first gate means (54 or 54, 66, 68) comprising first AND gate means (54) to the control input of the retimer means (30).

5.  A frequency divider as claimed in any one of Claims 1 to 4 wherein the counting means (42, 52, 62, 64) includes a plurality of flip-flops (42, 52, 62, 64) arranged in cascade with the output of one flip-flop (42, 52, 62) coupled to the clock input of the following flip-flops (52, 62, 64), and the outputs of the flip-flops (42, 52, 62, 64) being coupled via a gate arrangement (54, 66, 68) to said retiming means (30).

6.  A frequency divider as claimed in Claim 5 wherein the output of each flip-flop (42, 52, 62, 64) of the plurality of flip-flops (42, 52, 62, 64) is coupled to an input of a respective AND gate (54, 66, 68), another input of the AND gate (54, 66) being coupled to the output of the preceding AND gate (66, 68).

7.  A frequency divider according to any one of Claims 1 to 3 wherein: said first flip-flop means (203) comprises a dual modulus N/N+1 prescaler (203); said second flip-flop means (205) comprises a first preloadable counter (205); said gate means (213) comprises an AND gate (213); and said counting means (203, 205, 207) further includes a second preloadable counter (207) the clock input of which is coupled to said output of said first flip-flop means (203), said output of said second flip-flop means (205) controlling the preloading of said first (205) and second (207) counters, an output of said second counter (207) enabling and disabling the second counter (207) and controlling the N/N+1 divisor of said prescaler (203), said frequency divider having a divisor equalling N x Dn + Du, where Dn is the count preloaded into said first preloadable counter (205) and Du is the count preloaded into said second preloadable counter (207).

*Fig.1.*

*Fig.7.*

*Fig.2.*

# Fig.3.

# Fig.4A.

# Fig.4B.

NO TRANSITION ALLOWED FOR T

T MAY MAKE TRANSITION

## Fig.5A.

## Fig.5B.

Fig.6.

68
66
54
T 30 Q
Q̄
OUTPUT

Q̄ Q
64
D S

Q̄ Q
62
D S

Q̄ Q
52
D S

Q̄ Q
42
D S

6

CONTROL LEVEL SHIFT AND DECODE    70

72

SELECT RATIO

LOW NOISE ÷2$^N$

4
CLOCK
INPUT

EP 0 469 738 A2

9

# Fig.8.

I/P — 217

DUAL MODULUS
N/N+1 PRESCALER — 203

Q203

213

T  Q — 219  O/P

215

MODULUS
CONTROL
$N/\overline{N+1}$

Q203

205

209  $D_n$

FIRST
COUNTER

LOAD

= 0

Q205

PROGRAMMABLE
DIVIDER 201

207

LOAD

SECOND
COUNTER

211  $D_u$

EN

= 0

Q207

Q203